# EUROPEAN PATENT SPECIFICATION

(11) **EP 4 220 817 B1**
(45) Date of publication and mention of the grant of the patent: **17.12.2025**
(21) Application number: 21871605.8
(22) Date of filing: 24.09.2021
(51) Int. Cl.: H01M 10/44, H02J 7/00, H01M 10/42, H01M 10/48

(54) **BATTERY CHARGING METHOD AND SYSTEM BASED ON LITHIUM PLATING DETECTION, AND AUTOMOBILE AND MEDIUM**
BATTERIELADEVERFAHREN UND -SYSTEM AUF BASIS VON LITHIUMPLATTIERUNGSDETEKTION SOWIE AUTOMOBIL UND MEDIUM
PROCÉDÉ ET SYSTÈME DE CHARGE DE BATTERIE BASÉS SUR LA DÉTECTION DE PLACAGE DE LITHIUM, ET AUTOMOBILE ET SUPPORT

(30) Priority: 27.09.2020 CN 202011032994
(43) Date of publication of application: 02.08.2023
(73) Proprietor: BYD Company Limited, Shenzhen, Guangdong 518118 (CN)
(72) Inventor: FENG, Tianyu, Shenzhen, Guangdong 518118 (CN); SHU, Shiwei, Shenzhen, Guangdong 518118 (CN); DENG, Linwang, Shenzhen, Guangdong 518118 (CN); LI, Xiaoqian, Shenzhen, Guangdong 518118 (CN)
(74) Representative: Dehns Germany Partnerschaft mbB
(86) International application number: PCT/CN2021/120362
(87) International publication number: WO 2022/063236

(56) References cited:
- CN-A- 105 576 306
- CN-A- 106 099 230
- CN-A- 109 613 436
- CN-B- 106 099 230
- US-A1- 2016 111 898
- US-A1- 2020 212 684
- US-B2- 10 164 456

## Description

### FIELD

The present invention relates to the technical field of battery charging, and more specifically, to a battery charging method and system based on lithium plating detection, a vehicle, and a medium.

### BACKGROUND

With the development of science and technology, new energy vehicles are developing increasingly more rapidly. A battery is an important part of the new energy vehicle, and therefore users have imposed increasingly high requirements for a charging time of the vehicle battery. In this way, the battery charging time is further shortened, which can effectively improve vehicle use experience of the user.

In the related art, the battery is fast charged mainly through a control method for charging waveform optimization and a control method for model combination. The control method for optimizing a charging waveform includes optimizing a constant-current and constant-voltage charging method, a step charging method, a pulse charging method, an alternating current charging method, and the like. However, the method is an off-line method targeted at a fresh-from-the-factory battery without fully considering an actual change of the battery during actual use, resulting in low safety of the battery. The control method of the combination model includes methods such as combining an equivalent circuit model, combining a thermal model, combining an electrochemical model, combining a combined model of the forgoing models, and the like. Fast charging of the battery is implemented by using the forgoing models, but the method has the following shortcomings. An aging gap between batteries during use is relatively large, it is not difficult to accurately use a unified model for fast charging of the battery, and the model method has high costs.

CN 106 099 230 B discloses a lithium-ion battery rapid charging method capable of preventing lithium separation. US 2020/212684 A1 suggests to use an algorithm for a particular battery cell profile that is automatically generated and customized to minimize degradation due to fast charging for that particular batch.

### SUMMARY

The present invention according to the independent claims provides a battery charging method and system based on lithium plating detection, a vehicle, and a medium, to improve charging safety while implementing fast charging of a battery.

According to a first aspect, the present invention provides a battery charging method based on lithium plating detection, including:
acquiring a battery charging strategy table after receiving a battery charging instruction;
charging a battery according to a charging current in the battery charging strategy table, and performing at least one charging lithium plating detection on the battery during the charging of the battery, to obtain a first lithium plating detection result;
continuing the charging of the battery according to the charging current and the charging lithium plating detection of the battery during the charging of the battery when the first lithium plating detection result is that no lithium plating phenomenon occurs, and stopping the charging lithium plating detection of the battery when the first lithium plating detection result is that the lithium plating phenomenon occurs or the charging of the battery is completed; and
updating the charging current in the battery charging strategy table according to a preset first current reduction strategy when the first lithium plating detection result is that the lithium plating phenomenon occurs, and continuing the charging of the battery according to the updated charging current until the charging of the battery is completed, wherein the battery is charged using the updated charging current in the battery charging strategy table when receiving the charging instruction next time.

According to a second aspect, the present invention provides a battery charging system based on lithium plating detection, including:
a charging strategy table acquisition module, configured to acquire a battery charging strategy table after receiving a battery charging instruction;
a charging lithium plating detection module, configured to charge a battery according to a charging current in the battery charging strategy table, and perform at least one charging lithium plating detection on the battery during the charging of the battery, to obtain a first lithium plating detection result;
a first charging module, configured to: continue the charging of the battery according to the charging current and the charging lithium plating detection of the battery during the charging of the battery when the first lithium plating detection result is that no lithium plating phenomenon occurs, until the charging of the battery is completed; and
a second charging module, configured to update the charging current in the battery charging strategy table according to a preset first current reduction strategy when the first lithium plating detection result is that the lithium plating phenomenon occurs, and continue the charging of the battery according to the updated charging current until the charging of the battery is completed, wherein the battery is charged using the updated charging current in the battery charging strategy table when receiving the charging instruction next time.

According to a third aspect, the present invention provides a vehicle, including the battery charging system based on lithium plating detection.

According to a fourth aspect, the present invention provides a computer-readable storage medium. The computer-readable storage medium stores a computer program. When the computer program is executed by a processor, the battery charging method based on lithium plating detection is implemented.

According to the battery charging method and system based on lithium plating detection and the vehicle, the method includes: acquiring a battery charging strategy table after receiving a battery charging instruction; charging a battery according to a charging current in the battery charging strategy table, and performing at least one charging lithium plating detection on the battery during the charging of the battery, to obtain a first lithium plating detection result; continuing the charging of the battery according to the charging current and the charging lithium plating detection of the battery during the charging of the battery when the first lithium plating detection result is that no lithium plating phenomenon occurs, and stopping the charging lithium plating detection of the battery when the first lithium plating detection result is that the lithium plating phenomenon occurs or the charging of the battery is completed; and updating the charging current in the battery charging strategy table according to a preset first current reduction strategy when the first lithium plating detection result is that the lithium plating phenomenon occurs, and continuing the charging of the battery according to the updated charging current until the charging of the battery is completed.

According to the present disclosure, it is detected whether the lithium plating phenomenon occurs during the charging of the battery, and a present charging current of the battery is reduced according to the preset first current reduction strategy when the lithium plating phenomenon occurs to the battery. In this way, the characteristic of fast charging of the battery is further fully ensured while improving the safety of the battery in the charging process. In addition, the method in this embodiment may be applied to different types of batteries. It is only necessary to adjust the charging current in the battery charging strategy table of different types of batteries according to the first lithium plating detection result. Moreover, the method relates to a relatively small calculated amount, which reduces the computation complexity of the system, thereby improving the operating speed of the system.

### BRIEF DESCRIPTION OF THE DRAWINGS

In order to more clearly describe technical solutions in the embodiments of the present disclosure, the accompanying drawings required for description of embodiments of the present disclosure are briefly described below. , The invention is defined by the features of the independent claims. Preferred embodiments are defined in the dependent claims.
FIG. 1 is a flowchart of a battery charging method based on lithium plating detection according to an embodiment of the present disclosure.
FIG. 2 is another flowchart of a battery charging method based on lithium plating detection according to an embodiment of the present disclosure.
FIG. 3 is a schematic diagram of a voltage-time coordinate system in a battery charging method based on lithium plating detection according to an embodiment of the present disclosure.
FIG. 4 is a flowchart of step S20 of a battery charging method based on lithium plating detection according to an embodiment of the present disclosure.
FIG. 5 is a schematic block diagram of a battery charging system based on lithium plating detection according to an embodiment of the present disclosure.
FIG. 6 is another schematic block diagram of a battery charging system based on lithium plating detection according to an embodiment of the present disclosure,
FIG. 7 is a schematic diagram of a computer device according to an embodiment of the present disclosure.

### DETAILED DESCRIPTION

The technical solutions in the embodiments of the present disclosure are to be described clearly and completely with reference to the accompanying drawings in the embodiments of the present disclosure. Apparently, the described embodiments are some but not all of the embodiments of the present disclosure.

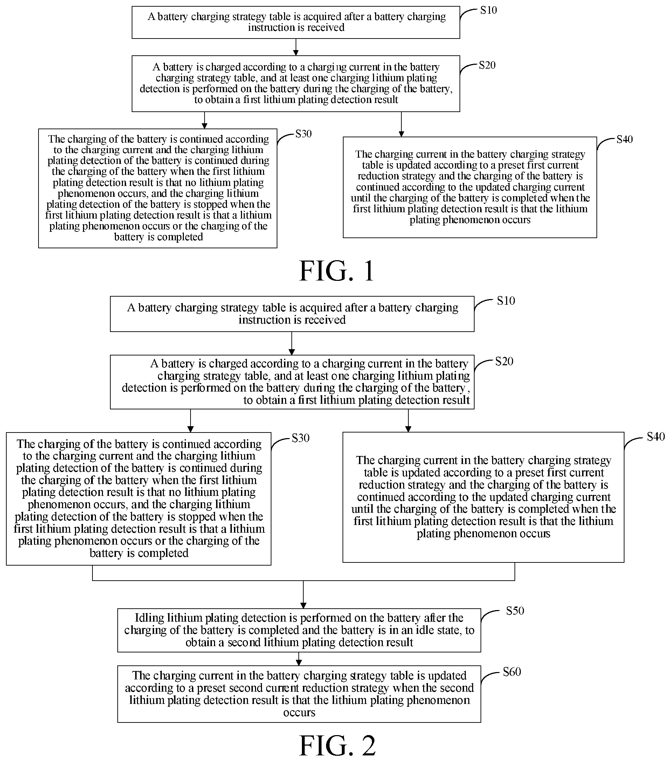

In an embodiment, as shown in FIG. 1, a battery charging method based on lithium plating detection is provided, including the following steps.

S10: A battery charging strategy table is acquired after a battery charging instruction is received.

The battery charging instruction is used for indicating that charging a power battery pack should be started at this time. For example, a user finds that a current state of charge (SOC) of the power battery pack is excessively low, and a vehicle is charged by using a charging pile at this time. At a moment of starting charging, the battery charging instruction is generated. The battery charging strategy table includes data related to battery charging, for example, a charging current, a charging voltage, and the like. The battery charging strategy table is obtained based on a fast charging strategy formulated by a factory when a battery leaves the factory. It may be understood that the charging current in the battery charging strategy table may be updated and adjusted depending on whether a lithium plating phenomenon occurs to the battery during charging and/or upon completion of charging of the battery. The lithium plating phenomenon is a phenomenon that lithium metal is deposited on a negative electrode of the battery.

S20: A battery is charged according to a charging current in the battery charging strategy table, and at least one charging lithium plating detection is performed on the battery during the charging of the battery, to obtain a first lithium plating detection result.

The charging lithium plating detection means a process of performing lithium plating phenomenon detection on the battery during the charging of the battery. The charging lithium plating detection includes but is not limited to the following methods: a three-electrode direct measurement method, a coulombic efficiency measurement method, and an electrochemical impedance measurement method. The first lithium plating detection result is obtained after the charging lithium plating detection is performed on the battery during the charging of the battery. The first lithium plating detection result includes two results: a lithium plating phenomenon occurs to the battery, and no lithium plating phenomenon occurs to the battery.

Specifically, the battery charging strategy table is acquired after the battery charging instruction is received, the battery is charged according to the charging current in the battery charging strategy table, and at least one charging lithium plating detection is performed on the battery during the charging of the battery, to obtain the first lithium plating detection result, so as to determine whether the lithium plating phenomenon occurs during the charging of the battery. If the lithium plating phenomenon occurs to the battery in the charging process, the charging current of the battery in the current charging process should be reduced, so as to inhibit lithium plating, and then reduce a lithium plating representation amount in the subsequent charging process. If no lithium plating phenomenon occurs to the battery in the charging process, the charging of the battery is continued by using the charging current in the current charging process, and the charging lithium plating detection of the battery is continued in the subsequent charging process until the charging of the battery is completed.

S30: When the first lithium plating detection result is that no lithium plating phenomenon occurs, the charging of the battery is continued according to the charging current, and the charging lithium plating detection of the battery is continued during the charging of the battery, and the charging lithium plating detection of the battery is stopped when the first lithium plating detection result is that a lithium plating phenomenon occurs or the charging of the battery is completed.

Specifically, after the battery is charged according to the charging current in the battery charging strategy table, and the charging lithium plating detection is performed on the battery during the charging of the battery, to obtain the first lithium plating detection result, the charging of the battery is continued according to the charging current in the battery charging strategy table and the charging lithium plating detection of the battery is continued during the charging of the battery when the first lithium plating detection result is that no lithium plating phenomenon occurs. When the first lithium plating detection result obtained at any subsequent moment is that the lithium plating phenomenon occurs, the charging lithium plating detection on the battery is stopped, the charging current in the battery charging strategy table is updated according to the preset first current reduction strategy, and the charging of the battery is continued according to the updated charging current until the charging of the battery is completed. When the first detection results obtained by subsequently performing charging lithium plating detection on the battery are that no lithium plating phenomenon occurs, it indicates that there is no need to update the charging current in the battery charging strategy table, and after the charging of the battery is completed, the charging lithium plating detection on the battery is stopped.

S40: When the first lithium plating detection result is that the lithium plating phenomenon occurs, the charging current in the battery charging strategy table is updated according to a preset first current reduction strategy, and the charging of the battery is continued according to the updated charging current until the charging of the battery is completed.

The preset first current reduction strategy means a strategy in which the present charging current is reduced by a preset proportion. For example, the first current reduction strategy may be reducing the charging current of the battery in the current charging process by the preset proportion. The preset proportion may be 0.1%-1% of the present charging current. For example, the preset proportion is 0.5% of the present charging current. In this way, when the charging current is 1 A, the charging current may be lowered by 0.5%. That is to say, the charging current is reduced to 0.995 A. It may be understood that it may be determined according to different situations whether the charging of the battery is completed. For example, it may be determined that the charging of the battery is completed after a present SOC value of the battery is set to reach a preset SOC value. In another scenario, the battery may also be powered off in advance. For example, if a sudden power outage prevents the battery from continuing being charged or the charging is ended in advance through manual operations (such as unplugging a charging plug from a charging pile), it may be considered that the battery is also charged at this time.

Specifically, after the battery is charged according to the charging current in the battery charging strategy table, and the charging lithium plating detection is performed on the battery during the charging of the battery to obtain the first lithium plating detection result, the charging current of the battery in the current charging process is reduced according to the preset first current reduction strategy when the first lithium plating detection result is that the lithium plating phenomenon occurs (since a lithium potential of the negative electrode of the battery is reduced to below 0 V when the lithium plating phenomenon occurs to the battery, a polarization phenomenon in the charging process more easily reduces the lithium potential of the negative electrode of the battery to a smaller value if the battery is still charged by using the present charging current, and therefore the present charging current of the battery needs to be reduced), and the reduced charging current is updated to the battery charging strategy table. The charging of the battery is continued according to the updated charging current in the battery charging strategy table (that is, the above reduced charging current), to reduce a probability that an increase in the lithium plating representation amount occurs to the battery in the subsequent charging process until the charging of the battery is completed, thereby ensuring safety of the battery in the charging process. That is to say, it indicates that if a lithium plating phenomenon occurring to the battery is detected in the charging process, there is no need to continue performing the charging lithium plating detection on the battery.

In this embodiment, it is detected whether the lithium plating phenomenon occurs to the battery during the charging of the battery, and when the lithium plating phenomenon occurs to the battery, the present charging current of the battery is reduced according to the preset first current reduction strategy. Therefore, it is ensured that the characteristic of fast charging of the battery is realized under the premise of safety while improving the safety of the battery in the charging process. In addition, the method in this embodiment may be applied to different types of batteries. It is only necessary to adjust the charging current in the battery charging strategy table of different types of batteries according to the first lithium plating detection result. Moreover, the method relates to a relatively small calculated amount, which reduces the computation complexity of the system, thereby improving the operating speed of the system.

In an embodiment, after step S30 or S40, as shown in FIG. 2, after the charging of the battery is completed, the following steps are included.

S50: Lithium plating detection is performed on the battery after the charging of the battery is completed and the battery is in an static state, to obtain a second lithium plating detection result.

The static state means a state in which no operation (such as discharging and charging) is performed on the battery. The lithium plating detection indicates a method for performing lithium plating detection on the battery after the charging of the battery is completed. The lithium plating detection includes but is not limited to the following methods: a voltage static method, a nonlinear frequency response method, a voltage relaxation method, and the like. The second lithium plating detection result is obtained after the lithium plating detection is performed on the battery after the charging of the battery is completed. The second lithium plating detection result includes two results: the lithium plating phenomenon occurs to the battery, and no lithium plating phenomenon occurs to the battery. In addition, when the second lithium plating detection result is that the lithium plating phenomenon occurs to the battery, the second lithium plating detection result may further represent the lithium plating representation amount of the battery.

Specifically, the charging of the battery is continued according to the updated charging current, and the charging lithium plating detection of the battery is continued during the charging of the battery until the charging of the battery is completed. The charged battery is caused to be in the static state, so as to perform lithium plating detection on the battery, to obtain the second lithium plating detection result.

In a specific embodiment, step S50 of performing lithium plating detection on the battery after the charging of the battery is completed and the battery is in the static state, to obtain the second lithium plating detection result includes the following steps:
regularly collecting a voltage of the battery at a preset time interval and associatively storing the collected voltage and a collection time of the voltage as voltage data after the charging of the battery is completed and the battery is in the static state.

The battery in the step is the battery that waits for lithium plating detection after being charged. The occurrence of lithium plating during the charging of the battery means that a part of lithium metal is deposited on the negative electrode of the battery during charging of the battery. The preset time interval may be determined according to an actual detection requirement (such as the detected battery type). For example, the preset time interval may be every 5s, every 10s, or the like. The collection time is a corresponding time point at which the voltage of the battery is collected according to the preset time interval. The voltage data includes each set of voltages and the collection times corresponding to the voltages.

A time-differential voltage curve is constructed in a voltage-time coordinate system according to the voltage data.

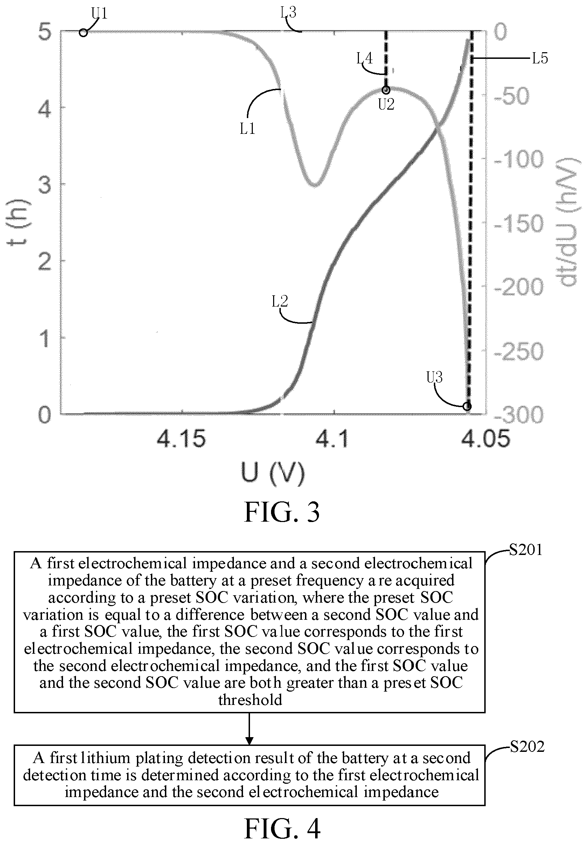

The time-differential voltage curve represents a curve of variation of a first derivative relationship of the battery with the voltage. The first derivative relationship is calculated according to the collection time and the voltages. The voltage-time coordinate system is the coordinate system shown in FIG. 3. The horizontal axis of the coordinate system represents the collected voltage of the battery, and the vertical axis represents the time corresponding to the collected voltage of the battery. L1 represents the time-differential voltage curve, and L2 represents the curve of the variation of the collected voltages of the battery with the collection times. Specifically, after the voltage of the battery is regularly collected at a preset time interval, and the collected voltage and the collection time of the voltage are associatively stored as voltage data, the time-differential voltage curve is determined after the first derivative relationship corresponding to the voltage data is obtained by using the time-differential voltage according to the voltage data.

Optionally, in the step, the determining the time-differential voltage curve according to the voltage data includes: generating the time-differential voltage curve according to the voltage data and a preset first derivative relationship. The preset first derivative relationship is calculated according to the voltage of each set of collected batteries and the collection time, and the preset first derivative relationship is *dt*/*dU .*

Specifically, after the voltage of the battery is regularly collected at the preset time interval, and the collected voltage and the collection time of the voltage are associatively stored as the voltage data, a preset first derivative relationship is obtained according to each set of voltages in the voltage data and the corresponding collection time. Since each collected voltage has a corresponding first derivative relationship value, the time-differential voltage curve is determined.

The second lithium plating detection result is obtained according to the time-differential voltage curve and a preset peak identification algorithm.

The preset peak identification algorithm is used for finding a characteristic peak voltage corresponding to the characteristic peak when the characteristic peak appears in the time-differential voltage curve, and the characteristic peak voltage is used for representing that the lithium plating phenomenon occurs to the battery during charging. In this embodiment, the peak identification algorithm may set a search region in the voltage-time coordinate system (for example, the region may be divided according to time). If the maximum value is found in the region (that is, as shown in FIG. 3, a point where the time-differential voltage curve L1 first rises and then falls indicates that the characteristic peak phenomenon occurs), the point corresponding to the maximum value is determined as the characteristic peak point.

Specifically, after the time-differential voltage curve is constructed in the voltage-time coordinate system according to the voltage data, it is found out whether a characteristic peak voltage exists in the time-differential voltage curve through a preset peak identification algorithm. If the characteristic peak voltage is found in the time-differential voltage curve, it indicates that the second lithium plating detection result is that the lithium plating phenomenon occurs to the battery after the charging is completed. If the characteristic peak voltage is not found in the time-differential voltage curve, it indicates that the second lithium plating detection result is that the lithium plating phenomenon does not occur to the battery after the charging is completed.

S60: When the second lithium plating detection result is that the lithium plating phenomenon occurs, the charging current in the battery charging strategy table is updated according to a preset second current reduction strategy.

The second current reduction strategy means that the reduction proportion of the charging current that needs to be reduced is determined according to the lithium plating representation amount after the charging of the battery is completed and the lithium plating standard corresponding to the battery, and then the charging current in the battery charging strategy table is updated and reduced according to the reduction proportion. For example, the reduction proportion is 1% of the present charging current. In this way, when the charging current in the battery charging strategy table is 1 A, the charging current may be lowered by 1%. That is to say, the charging current is reduced to 0.99 A. It may be understood that in the present disclosure, the preset proportion of the first current reduction strategy and the reduction proportion in the second current reduction strategy may or may not be the same.

Specifically, after the lithium plating detection is performed on the battery to obtain the second lithium plating detection result, the lithium plating representation amount of the battery is further confirmed when the second lithium plating detection result is that a lithium plating phenomenon occurs, to obtain the lithium plating representation amount corresponding to the lithium plating phenomenon after the charging of the battery is completed. The charging current in the battery charging strategy table is then updated according to the lithium plating representation amount and the preset second current reduction strategy.

Optionally, step S60 of updating the charging current in the battery charging strategy table according to the preset second current reduction strategy when the second lithium plating detection result is that the lithium plating phenomenon occurs includes the following steps:
identifying a characteristic peak voltage in the time-differential voltage curve through the preset peak identification algorithm, and recording a corresponding stable voltage when the time-differential voltage curve reaches a preset stability standard after determining the characteristic peak voltage.

The preset stability standard means that the curve value of the time-differential voltage curve satisfies the following requirements of being in the range of -100 to - ∞ and approaching a stable state. In this embodiment, when the variation of the time-differential voltage curve with the voltage is particularly small within a long time (the curve approaches a straight line, and the curve value of the time-differential voltage curve approaches a stable state at this time), a corresponding voltage value in the time-differential voltage curve at the beginning of the state is recorded as a stable voltage.

Specifically, after the time-differential voltage curve is determined according to the voltage data, the characteristic peak voltage in the time-differential voltage curve is identified through the peak identification algorithm, which indicates that the lithium plating phenomenon occurs in the charging process of the battery, that is, it is determined that the battery has a lithium plating state in the charging process. In this case, it is necessary to record the corresponding stable voltage when the time-differential voltage curve reaches the preset stability standard after the characteristic peak voltage is determined.

A first region area and a second region area are determined in the voltage-time coordinate system according to the characteristic peak voltage, the stable voltage, and the time-differential voltage curve.

Specifically, after the characteristic peak voltage in the time-differential voltage curve is identified through the peak identification algorithm, and the corresponding stable voltage when the time-differential voltage curve reaches the preset stability standard is recorded after the characteristic peak voltage occurs, a charging voltage at the end of charging the battery is acquired. A starting point of the time-differential voltage curve corresponds to the charging voltage. A horizontal reference axis and a first vertical reference axis are determined. The horizontal reference axis is the horizontal axis corresponding to the starting point in the voltage-time coordinate system, and the first vertical reference axis is the vertical axis corresponding to the characteristic peak voltage in the voltage-time coordinate system. A first region area corresponding to a region jointly defined by the horizontal reference axis, the first vertical reference axis, and the time-differential voltage curve is calculated. In the voltage-time coordinate system shown in FIG. 3, U1 is the starting point corresponding to the charging voltage in the time-differential voltage curve, U2 is the point corresponding to the characteristic peak voltage in the time-differential voltage curve, U3 is the point corresponding to the stable voltage in the time-differential voltage curve, L3 is the horizontal reference axis, L4 is the first vertical reference axis, and L5 is the second vertical reference axis.

The second vertical reference axis is determined. The second vertical reference axis is the vertical axis corresponding to the stable voltage in the voltage-time coordinate system. A second region area corresponding to a region jointly defined by the horizontal reference axis, the first vertical reference axis, the second vertical reference axis, and the time-differential voltage curve is calculated.

The lithium plating representation amount of the battery is determined according to the first region area and the second region area. The charging current in the battery charging strategy table is updated according to the lithium plating representation amount and a preset battery lithium plating standard.

The lithium plating representation amount represents the degree of lithium plating of the battery during charging. The preset battery lithium plating standard is the lithium plating standard obtained by detecting the batteries before leaving the factory, that is, each battery has a corresponding preset battery lithium plating standard.

Specifically, after the first region area is obtained according to the characteristic peak voltage and the time-differential voltage curve, and the second region area is obtained according to the characteristic peak voltage, the stable voltage, and the time-differential voltage curve, the lithium plating representation amount of the battery is determined according to the first region area and the second region area. Then the severity of lithium plating occurring to the battery during the charging at this time may be determined according to the lithium plating standard of the battery in the factory specification (that is, the preset battery lithium plating standard). If the lithium plating representation amount exceeds the corresponding lithium plating standard of the battery, the second current reduction strategy should be adopted to reduce the present charging current in the battery charging strategy table. That is to say, the reduction proportion of the charging current that needs to be reduced is determined according to the difference between the lithium plating representation amount after the battery charging and the lithium plating standard, and then the charging current in the battery charging strategy table is updated and reduced according to the reduction proportion. For example, the lithium plating representation amount after the battery charging exceeds the lithium plating standard, and the reduction proportion is preset to 1% of the present charging current. If the charging current in the battery charging strategy table is 1 A, in this case, the charging current may be lowered by 1%, that is, the charging current may be reduced to 0.99 A. In this way, the battery may be charged by using the lowered charging current in the next charging, thereby reducing the lithium plating representation amount of the battery and further achieving the effect of protecting the battery. It may be understood that if the lithium plating representation amount seriously exceeds the corresponding lithium plating standard of the battery (for example, the excess amount is greater than or equal to a preset percentage of the lithium plating standard), for example, the preset percentage may be 40%. However, the preset percentage may also be set to other percentages besides 40% according to the requirements. It may be understood that when the excess amount is less than the preset percentage, the present charging current in the battery charging strategy table can be reduced according to the second current reduction strategy, which indicates that the battery should be returned to the factory for maintenance to avoid occurrence of safety accidents caused by the excessive lithium plating representation amount of the battery.

It should be noted that the time point when the characteristic peak voltage appears in the time-differential voltage curve is a time point when active lithium is completely intercalated in graphite. That is to say, the physical meaning of the first region area means a duration required for the "active lithium" deposited during charging of the battery to be intercalated from the outside of graphite into the inside. However, the second region area corresponding to the characteristic peak voltage to the stable voltage indicates that the lithium ion concentration is basically balanced from the diaphragm to the copper foil. Therefore, lithium ions tend to diffuse from the outside of the graphite particles to the inside of the particles, so that the lithium ions in the whole graphite particles are evenly distributed.

Specifically, the physical meaning of the first region area means a duration required for the "active lithium" deposited during charging of the battery to be intercalated from the outside of graphite into the inside. It is not accurate to represent the total lithium plating representation amount of the battery only by using the first region area, because the duration is related to the lithium plating representation amount and the lithium intercalation rate of graphite, and the lithium intercalation rate of graphite is also related to the temperature. Therefore, the duration may be used for representing the lithium plating representation amount under the same temperature.

Therefore, the present invention uses the reciprocal of the second region area to represent the lithium plating rate of the battery. However, within the collection time of the first region area, part of the "active lithium" that has entered the negative electrode has started to be in equilibrium during the intercalation of other "active lithium" into the negative electrode. Therefore, the time when part of the "active lithium" is in equilibrium in the negative electrode coincides with the collection time of the first region area. However, before the characteristic peak voltage is reached, "active lithium" mainly enters the negative electrode, and after the characteristic peak voltage is reached, the concentration difference of lithium ions in graphite particles in the negative electrode is a rate of lithium intercalation in the graphite (that is, the lithium plating rate) represented by a reciprocal of a time from complete intercalation of all the "active lithium" in the negative electrode to final equilibrium reached by graphite particles in the negative electrode (that is, the second region area).

It is pointed out according to the above description that the first region area may be recorded as the lithium plating duration of the battery, and the reciprocal of the second region area is recorded as the lithium plating rate of the battery. Further, the product of the reciprocal of the second region area and the first region area is recorded as the lithium plating representation amount of the battery, that is, the product of the lithium plating duration and the lithium plating rate is recorded as the lithium plating representation amount of the battery.

In another specific embodiment, after the lithium plating detection is performed on the battery to obtain the second lithium plating detection result, the method further includes the following.

When the second lithium plating detection result is that no lithium plating phenomenon occurs, that is, after the charging of the battery is completed, no lithium plating phenomenon occurs, it indicates that in the next charging process of the battery, the battery is charged by using the present charging current in the battery charging strategy table without increasing the lithium plating representation amount of the battery, and the charging current in the battery charging strategy table is not updated. Optionally, when the characteristic peak voltage in the time-differential voltage curve is not identified through the peak identification algorithm, it is prompted that no lithium plating phenomenon occurs to the battery during charging. Specifically, since the characteristic peak voltage is used for representing the occurrence of lithium plating of the battery in the charging process in a physical sense in the present disclosure, after the time-differential voltage curve is determined according to the voltage data, it indicates that no lithium plating phenomenon occurs to the battery during charging when the characteristic peak voltage in the time-differential voltage curve is not identified through the peak identification algorithm.

In this embodiment, after the charging of the battery is completed, the battery is allowed to stand for lithium plating detection, to determine whether the lithium plating phenomenon occurs to the battery after being charged, and when the lithium plating phenomenon occurs to the battery, the present charging current of the battery is reduced according to the preset second current reduction strategy, so as to improve the safety of the battery in the charging process. In addition, it is ensured that the battery is charged by using the updated charging current in the battery charging strategy table when receiving the charging instruction next time, so as to avoid the lithium plating phenomenon and further improve the safety of the battery.

In an embodiment, as shown in FIG. 3, step S20 of performing at least one charging lithium plating detection on the battery during the charging of the battery to obtain the first lithium plating detection result includes the following steps.

S201: A first electrochemical impedance and a second electrochemical impedance of the battery at a preset frequency are acquired according to a preset SOC variation, where the preset SOC variation is equal to a difference between a second SOC value and a first SOC value, the first SOC value corresponds to the first electrochemical impedance, the second SOC value corresponds to the second electrochemical impedance, and the first SOC value and the second SOC value are both greater than a preset SOC threshold.

In one charging lithium plating detection, the first SOC value is a ratio of a current remaining capacity of the battery before the charging lithium plating detection to a capacity of the battery in a fully charged state, and the second SOC value is a ratio of the current remaining capacity of the battery after the charging lithium plating detection to the capacity of the battery in a fully charged state. Optionally, the preset SOC threshold may be determined according to the type of the battery and the charging requirement. For example, the preset SOC threshold may be 70%, 75%, and the like. An electrochemical impedance is a ratio of an AC voltage to a current signal of the battery during charging, and the electrochemical impedance corresponds to the SOC value and the preset frequency of the battery (for example, the first electrochemical impedance corresponds to the first SOC value and the preset frequency, and the second electrochemical impedance corresponds to the second SOC value and the preset frequency). For example, a preset frequency may be any value selected from a frequency range of 0.01 Hz to 10 Hz. The preset frequency may be determined according to the type of the battery, that is, different types of batteries (such as a power battery and a 3C battery) correspond to different preset frequencies.

Optionally, the preset SOC variation may be set according to requirements, for example, set to 5%, 10%, and the like. Assuming that the preset SOC variation is 5% and the preset SOC threshold is 70%, the first SOC value may be 75% and the second SOC value may be 80%.

Specifically, in this embodiment, the electrochemical impedance measurement method is used for performing charging lithium plating detection on the battery. After the battery is charged according to the charging current in the battery charging strategy table, the first electrochemical impedance and the second electrochemical impedance of the battery at the preset frequency are acquired according to the preset SOC variation.

In a specific implementation, it is assumed that only one charging lithium plating detection is performed on the battery during charging, and the first lithium plating detection result is that the lithium plating phenomenon occurs to the battery during charging, and only one set of corresponding first electrochemical impedance and second electrochemical impedance exist in this charging lithium plating detection. That is to say, the first lithium plating detection result determined according to the set of first electrochemical impedance and second electrochemical impedance is that the lithium plating phenomenon occurs to the battery during charging.

In another specific implementation, it is assumed that multiple charging lithium plating detections are performed on the battery during charging, and the last lithium plating detection result is that the lithium plating phenomenon occurs to the battery during charging. In this case, multiple sets of corresponding first electrochemical impedance and second electrochemical impedance exist in the charging lithium plating detection. When the first lithium plating detection result is that no lithium plating phenomenon occurs to the battery charging process, the second electrochemical impedance at this time may be used as a new first electrochemical impedance for the next charging lithium plating detection, a new second electrochemical impedance corresponding to the new first electrochemical impedance is obtained according to the preset SOC variation, and a new first lithium plating detection result is determined according to the new first electrochemical impedance and the new second electrochemical impedance. A difference between the second SOC value and the first SOC value in each set that correspond to each other is equal to the preset SOC variation.

S202: The first lithium plating detection result of the battery at a second detection time is determined according to the first electrochemical impedance and the second electrochemical impedance.

Specifically, After the second electrochemical impedance of the battery at a preset frequency at the second detection time is acquired, the first electrochemical impedance is compared with the second electrochemical impedance, and then the first lithium plating detection result of the battery at the second detection time is determined according to the result obtained after comparison.

After the first electrochemical impedance is compared with the second electrochemical impedance, it is determined that the first lithium plating detection result at the second detection time is that the lithium plating phenomenon occurs when the first electrochemical impedance is greater than the second electrochemical impedance.

After the first electrochemical impedance is compared with the second electrochemical impedance, it is determined that the first lithium plating detection result at the second detection time is that no lithium plating phenomenon occurs when the first electrochemical impedance is less than or equal to the second electrochemical impedance.

It should be understood that the sequence number of steps in the above embodiments does not mean the order of execution, and the order of execution of each process should be determined by its function and internal logic, and should not constitute any limitation on the implementation process of the embodiments of the present disclosure.

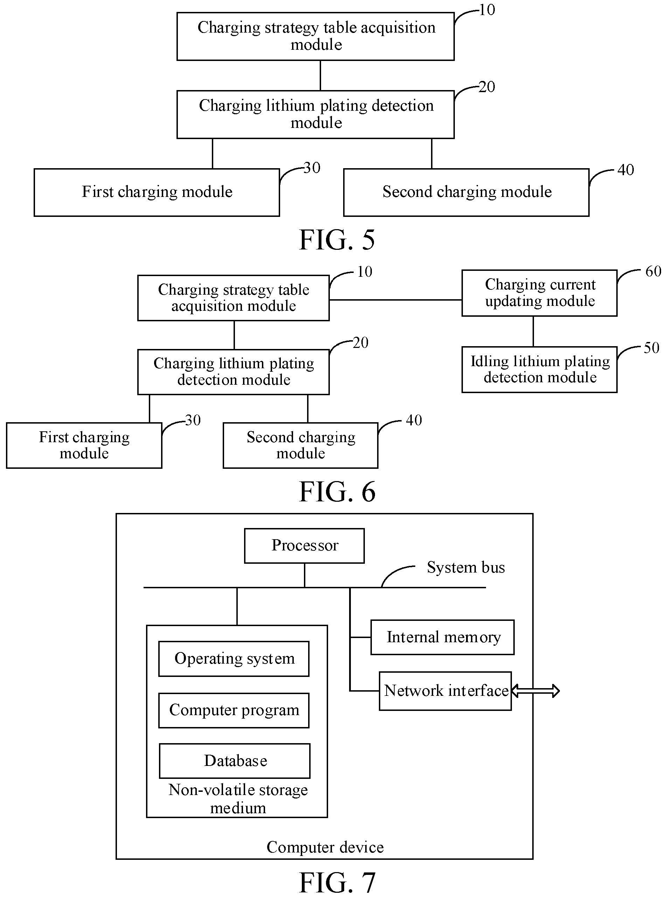

In an embodiment, as shown in FIG. 5, a battery charging system based on lithium plating detection is provided, including the following modules:
a charging strategy table acquisition module 10, configured to acquire a battery charging strategy table after receiving a battery charging instruction;
a charging lithium plating detection module 20, configured to: charge a battery according to a charging current in the battery charging strategy table, and perform at least one charging lithium plating detection on the battery during the charging of the battery, to obtain a first lithium plating detection result;
a first charging module 30, configured to: continue the charging of the battery according to the charging current and the charging lithium plating detection of the battery during the charging of the battery, when the first lithium plating detection result is that no lithium plating phenomenon occurs, and stop the charging lithium plating detection of the battery when the first lithium plating detection result is that a lithium plating phenomenon occurs or the charging of the battery is completed; and
a second charging module 40, configured to update the charging current in the battery charging strategy table according to a preset first current reduction strategy when the first lithium plating detection result is that the lithium plating phenomenon occurs, and continue the charging of the battery according to the updated charging current until the charging of the battery is completed.

Optionally, as shown in FIG. 6, the battery charging system based on lithium plating detection further includes the following modules:
an lithium plating detection module 50, configured to perform lithium plating detection on the battery after the charging of the battery is completed and the battery is in an static state, to obtain a second lithium plating detection result; and
a charging current updating module 60, configured to update the charging current in the battery charging strategy table according to a preset second current reduction strategy when the second lithium plating detection result is that the lithium plating phenomenon occurs.

Optionally, the lithium plating detection module 50 includes the following units:
a voltage collection unit, configured to regularly collect a voltage of the battery at a preset time interval and associatively store the collected voltage and a collection time of the voltage as voltage data after the charging of the battery is completed and the battery is in the static state;
a curve construction unit, configured to construct a time-differential voltage curve in a voltage-time coordinate system according to the voltage data; and
a peak identification unit, configured to obtain the second lithium plating detection result according to the time-differential voltage curve and a preset peak identification algorithm.

Optionally, the charging current updating module 60 includes the following units:
a voltage recording unit, configured to identify a characteristic peak voltage in the time-differential voltage curve through the preset peak identification algorithm, and record a corresponding stable voltage when the time-differential voltage curve reaches a preset stability standard after determining the characteristic peak voltage;
an area determining unit, configured to determine a first region area and a second region area in the voltage-time coordinate system according to the characteristic peak voltage, the stable voltage, and the time-differential voltage curve;
a lithium plating representation amount determining unit, configured to determine a lithium plating representation amount of the battery according to the first region area and the second region area; and
a current updating unit, configured to update the charging current in the battery charging strategy table according to the lithium plating representation amount and a preset battery lithium plating standard.

Optionally, the charging lithium plating detection module 20 includes the following units:
an electrochemical impedance acquisition unit, configured to acquire the first electrochemical impedance and the second electrochemical impedance of the battery at the preset frequency according to the preset SOC variation, where the first SOC value corresponding to the first electrochemical impedance and the second SOC value corresponding to the second electrochemical impedance are both greater than the preset SOC threshold, and a difference between the second SOC value and the first SOC value is equal to the preset SOC variation; and
a lithium plating detection result acquisition unit, configured to acquire the first lithium plating detection result according to the first electrochemical impedance and the second electrochemical impedance.

Optionally, the lithium plating detection result acquisition unit includes the following subunits:
a first impedance comparison unit, configured to determine that the first lithium plating detection result is that the lithium plating phenomenon occurs when the first electrochemical impedance is greater than the second electrochemical impedance; and
a second impedance comparison unit, configured to determine that the first lithium plating detection result is that no lithium plating phenomenon occurs when the first electrochemical impedance is less than or equal to the second electrochemical impedance.

In an embodiment, a vehicle is provided, including the battery charging system based on lithium plating detection.

In an embodiment, a computer device is provided. The computer device may be a server. An internal structure diagram of the server may be shown in FIG. 7. The computer device includes a processor, a memory, a network interface, and a database connected through a system bus. The processor of the computer device is configured to provide computing and control capabilities. The memory of the computer device includes a non-volatile storage medium and an internal memory. The non-volatile storage medium stores an operating system, a computer program, and a database. The internal memory provides an environment for the running of the operating system and the computer program in the non-volatile storage medium. The network interface of the computer device is configured to communicate with an external terminal through network connection. When the computer program is executed by a processor, the battery charging method based on lithium plating detection is implemented.

In an embodiment, a computer device is provided, including a memory, a processor, and a computer program stored on the memory and executable by the processor. When the computer program is executed by the processor, the battery charging method based on lithium plating detection in the above embodiment is implemented.

In an embodiment, a computer-readable storage medium is provided, storing a computer program, the computer program, when executed by a processor, implementing the battery charging method based on lithium plating detection in the embodiment.

A person of ordinary skill in the art may understand that all or some of process of the method in the foregoing embodiments may be implemented by using a computer program to instruct relevant hardware. The computer program may be stored in a non-volatile computer-readable storage medium. When the computer program is executed, the process of the foregoing method embodiments may be included. Any reference to the memory, storage, the database, or other media used in the embodiments provided in the present disclosure may include a non-volatile memory or a volatile memory. The non-volatile memory may include a read-only memory (ROM), a programmable ROM (PROM), an electrically programmable ROM (EPROM), an electrically erasable programmable ROM (EEPROM), or a flash memory. The volatile memory may include a RAM or an external cache memory. By way of description rather than limitation, the RAM may be obtained in multiple forms, such as a static RAM (SRAM), a dynamic RAM (DRAM), a synchronous DRAM (SDRAM), a double data rate SDRAM (DDRSDRAM), an enhanced SDRAM (ESDRAM), a Synchlink DRAM (SLDRAM), a Rambus Direct RAM (RDRAM), a Direct Rambus Dynamic RAM (DRDRAM), and a Rambus Dynamic RAM (RDRAM).

It can be clearly understood by those skilled in the art that for the convenience and conciseness of description, only the division of the above functional units and modules is used as an example for description. In practical application, the above functional allocation may be completed by different functional units and modules as required, that is, the internal structure of the device is divided into different functional units or modules to complete all or part of the functions described above.

## Claims

1. A battery charging method based on lithium plating detection, comprising:
acquiring (S10) a battery charging strategy table after receiving a battery charging instruction;
charging (S20) a battery according to a charging current in the battery charging strategy table, and performing at least one charging lithium plating detection on the battery during the charging of the battery, to obtain a first lithium plating detection result;
continuing (S30) the charging of the battery according to the charging current and the charging lithium plating detection of the battery during the charging of the battery when the first lithium plating detection result is that no lithium plating phenomenon occurs, and stopping the charging lithium plating detection of the battery when the first lithium plating detection result is that the lithium plating phenomenon occurs or the charging of the battery is completed; and **characterized by**
updating (S40) the charging current in the battery charging strategy table according to a preset first current reduction strategy when the first lithium plating detection result is that the lithium plating phenomenon occurs, and continuing the charging of the battery according to the updated charging current until the charging of the battery is completed, wherein the battery is charged using the updated charging current in the battery charging strategy table when receiving the charging instruction next time.

2. The battery charging method based on lithium plating detection according to claim 1, wherein after the charging of the battery is completed, the method comprises:
performing (S50) lithium plating detection on the battery after the charging of the battery is completed and the battery is in a static state, to obtain a second lithium plating detection result; and
updating (S60) the charging current in the battery charging strategy table according to a preset second current reduction strategy when the second lithium plating detection result is that the lithium plating phenomenon occurs.

3. The battery charging method based on lithium plating detection according to claim 2, wherein the performing (S50) lithium plating detection on the battery after the charging of the battery is completed and the battery is in a static state, to obtain a second lithium plating detection result comprises:
regularly collecting a voltage of the battery at a preset time interval after the charging of the battery is completed and the battery is in a static state, and associatively storing the collected voltage and a collection time of the voltage as voltage data;
constructing a time-differential voltage curve (L1) in a voltage-time coordinate system according to the voltage data; and
obtaining the second lithium plating detection result according to the time-differential voltage curve (L1) and a preset peak identification algorithm.

4. The battery charging method based on lithium plating detection according to claim 3, wherein the updating (S60) the charging current in the battery charging strategy table according to a preset second current reduction strategy comprising:
identifying a characteristic peak voltage (U2) in the time-differential voltage curve (L1) through the preset peak identification algorithm, and recording a corresponding stable voltage (U3) when the time-differential voltage curve (L1) reaches a preset stability standard after determining the characteristic peak voltage;
determining a first region area and a second region area in the voltage-time coordinate system according to the characteristic peak voltage (U2), the stable voltage (U3), and the time-differential voltage curve;
determining a lithium plating representation amount of the battery according to the first region area and the second region area; and
updating the charging current in the battery charging strategy table according to the lithium plating representation amount and a preset battery lithium plating standard.

5. The battery charging method based on lithium plating detection according to any of claims 1 to 4, wherein the performing (50) at least one charging lithium plating detection on the battery during the charging of the battery, to obtain a first lithium plating detection result comprises:
acquiring (S201) a first electrochemical impedance and a second electrochemical impedance of the battery at a preset frequency according to a preset SOC variation, wherein the preset SOC variation is equal to a difference between a second SOC value and a first SOC value; the first SOC value corresponds to the first electrochemical impedance; the second SOC value corresponds to the second electrochemical impedance; and the first SOC value and the second SOC value are both greater than a preset SOC threshold; and
acquiring (S202) the first lithium plating detection result according to the first electrochemical impedance and the second electrochemical impedance.

6. The battery charging method based on lithium plating detection according to claim 5, wherein the acquiring (S201) the first lithium plating detection result of the battery according to the first electrochemical impedance and the second electrochemical impedance comprises:
determining that the first lithium plating detection result is that the lithium plating phenomenon occurs when the first electrochemical impedance is greater than the second electrochemical impedance; and
determining that the first lithium plating detection result is that no lithium plating phenomenon occurs when the first electrochemical impedance is less than or equal to the second electrochemical impedance.

7. A battery charging system based on lithium plating detection, comprising:
a charging strategy table acquisition module (10), configured to acquire a battery charging strategy table after receiving a battery charging instruction;
a charging lithium plating detection module (20), configured to charge a battery according to a charging current in the battery charging strategy table, and perform at least one charging lithium plating detection on the battery during the charging of the battery, to obtain a first lithium plating detection result;
a first charging module (30), configured to: continue the charging of the battery according to the charging current and the charging lithium plating detection of the battery during the charging of the battery when the first lithium plating detection result is that no lithium plating phenomenon occurs, and stop the charging lithium plating detection of the battery when the first lithium plating detection result is that the lithium plating phenomenon occurs or the charging of the battery is completed; and **characterized by**
a second charging module (40), configured to update the charging current in the battery charging strategy table according to a preset first current reduction strategy when the first lithium plating detection result is that the lithium plating phenomenon occurs, and continue the charging of the battery according to the updated charging current until the charging of the battery is completed, wherein the battery is charged using the updated charging current in the battery charging strategy table when receiving the charging instruction next time.

8. The battery charging system based on lithium plating detection according to claim 7, further comprising:
a lithium plating detection module (50), configured to perform lithium plating detection on the battery after the charging of the battery is completed and the battery is in an static state, to obtain a second lithium plating detection result; and
a charging current updating module (60), configured to update the charging current in the battery charging strategy table according to a preset second current reduction strategy when the second lithium plating detection result is that the lithium plating phenomenon occurs.

9. A vehicle, comprising the battery charging system based on lithium plating detection according to claim 7 or 8.

10. A computer-readable storage medium, storing a computer program, wherein when the computer program is executed by a processor, the battery charging method based on lithium plating detection according to any of claims 1 to 6 is implemented.

## Patentansprüche

1. Batterieladungsverfahren auf Basis der Lithiumplattierung, umfassend:
Erfassen (S10) einer Batterieladestrategietabelle nach Erhalt einer Batterieladeanweisung;
Laden (S20) einer Batterie gemäß einem Ladestrom in der Batterieladestrategietabelle und Durchführen mindestens einer Lithiumplattierungsdetektierung an der Batterie während des Ladens der Batterie, um ein erstes Lithiumplattierungsdetektierergebnis zu erhalten;
Fortsetzen (S30) des Ladens der Batterie gemäß dem Ladestrom und des Detektieren der Lithiumplattierung der Batterie während des Ladens der Batterie, wenn das erste Ergebnis des Detektieren der Lithiumplattierung lautet, dass kein Lithiumplattierungsphänomen auftritt, und Beenden des Detektieren der Lithiumplattierung der Batterie, wenn das erste Ergebnis des Detektieren der Lithiumplattierung lautet, dass das Lithiumplattierungsphänomen auftritt oder das Laden der Batterie abgeschlossen ist; und **gekennzeichnet durch**
Aktualisieren (S40) des Ladestroms in der Batterieladestrategietabelle gemäß einer voreingestellten ersten Stromreduzierungsstrategie, wenn das erste Lithiumplattierungsergebnis lautet, dass das Lithiumplattierungsphänomen auftritt, und Fortsetzen des Ladens der Batterie gemäß dem aktualisierten Ladestrom, bis das Laden der Batterie abgeschlossen ist, wobei die Batterie unter Verwendung des aktualisierten Ladestroms in dem Batterieladestrategietabelle geladen wird, wenn der nächste Ladeauftrag empfangen wird.

2. Batterieladungsverfahren auf der Grundlage des Detektieren der Lithiumplattierung gemäß Anspruch 1, wobei das Verfahren nach Abschluss des Ladevorgangs der Batterie Folgendes umfasst:
Durchführen (S50) einer Lithiumplattierungsdetektion an der Batterie, nachdem das Laden der Batterie abgeschlossen ist und sich die Batterie in einem statischen Zustand befindet, um ein zweites Lithiumplattierungsdetektionsergebnis zu erhalten; und
Aktualisieren (S60) des Ladestroms in der Batterieladestrategietabelle gemäß einer voreingestellten zweiten Stromreduzierungsstrategie, wenn das zweite Lithiumplattierungsergebnis Detektiert, dass das Lithiumplattierungsphänomen auftritt.

3. Batterieladungsverfahren auf der Grundlage des Detektieren der Lithiumplattierung gemäß Anspruch 2, wobei das Durchführen (S50) des Detektieren der Lithiumplattierung an der Batterie, nachdem das Laden der Batterie abgeschlossen ist und sich die Batterie in einem statischen Zustand befindet, um ein zweites Lithiumplattierungserkennungsergebnis zu erhalten, umfasst:
regelmäßiges Erfassen einer Spannung der Batterie in einem voreingestellten Zeitintervall, nachdem das Laden der Batterie abgeschlossen ist und sich die Batterie in einem statischen Zustand befindet, und assoziatives Speichern der erfassten Spannung und einer Erfassungszeit der Spannung als Spannungsdaten;
Erstellen einer Zeitdifferenz-Spannungskurve (L1) in einem Spannungs-Zeit-Koordinatensystem gemäß den Spannungsdaten; und
Detektieren des zweiten Lithiumplattierungserkennungsergebnisses gemäß der Zeitdifferenz-Spannungskurve (L1) und einem voreingestellten Spitzenwert-Identifizierungsalgorithmus.

4. Batterieladungsverfahren auf der Grundlage des Detektieren der Lithiumplattierung gemäß Anspruch 3, wobei das Aktualisieren (S60) des Ladestroms in der Batterieladestrategietabelle gemäß einer voreingestellten zweiten Stromreduzierungsstrategie umfasst:
Identifizieren einer charakteristischen Spitzenspannung (U2) in der Zeit-Differenz-Spannungskurve (L1) durch den voreingestellten Spitzenidentifizierungsalgorithmus und Aufzeichnen einer entsprechenden stabilen Spannung (U3), wenn die Zeit-Differenz-Spannungskurve (L1) nach Bestimmung der charakteristischen Spitzenspannung einen voreingestellten Stabilitätsstandard erreicht;
Bestimmen eines ersten Bereichs und eines zweiten Bereichs in dem Spannungs-Zeit-Koordinatensystem gemäß der charakteristischen Spitzenspannung (U2), der stabilen Spannung (U3) und der zeitdifferenziellen Spannungskurve;
Bestimmen einer Lithium-Plattierungsdarstellungsmenge der Batterie gemäß dem ersten Bereich und dem zweiten Bereich; und
Aktualisieren des Ladestroms in der Batterieladestrategietabelle gemäß der Lithium-Plattierungsdarstellungsmenge und einem voreingestellten Batterie-Lithium-Plattierungsstandard.

5. Batterieladungsverfahren auf der Grundlage des Detektieren der Lithiumplattierung gemäß einem der Ansprüche 1 bis 4, wobei das Durchführen (50) mindestens einer Ladungs-Lithiumplattierungskennungsdetektion an der Batterie während des Ladens der Batterie, um ein erstes Lithiumplattierungserkennungsergebnis zu erhalten, umfasst:
Erfassen (S201) einer ersten elektrochemischen Impedanz und einer zweiten elektrochemischen Impedanz der Batterie bei einer voreingestellten Frequenz gemäß einer voreingestellten SOC-Variation, wobei die voreingestellte SOC-Variation gleich der Differenz zwischen einem zweiten SOC-Wert und einem ersten SOC-Wert ist; der erste SOC-Wert der ersten elektrochemischen Impedanz entspricht; der zweite SOC-Wert entspricht der zweiten elektrochemischen Impedanz; und der erste SOC-Wert und der zweite SOC-Wert sind beide größer als ein voreingestellter SOC-Schwellenwert; und
Erfassen (S202) des ersten Lithiumplattierungserkennungsergebnisses gemäß der ersten elektrochemischen Impedanz und der zweiten elektrochemischen Impedanz.

6. Verfahren zum Laden einer Batterie auf der Grundlage des Detektierens einer Lithiumplattierung gemäß Anspruch 5, wobei das Erfassen (S201) des ersten Lithiumplattierungserkennungsergebnisses der Batterie gemäß der ersten elektrochemischen Impedanz und der zweiten elektrochemischen Impedanz umfasst:
Bestimmen, dass das erste Lithiumplattierungserkennungsergebnis darin besteht, dass das Lithiumplattierungsphänomen auftritt, wenn die erste elektrochemische Impedanz größer als die zweite elektrochemische Impedanz ist; und
Feststellen, dass das erste Lithiumplattierungserkennungsergebnis darin besteht, dass kein Lithiumplattierungsphänomen auftritt, wenn die erste elektrochemische Impedanz kleiner oder gleich der zweiten elektrochemischen Impedanz ist.

7. Batterieladesystem auf der Grundlage der Lithiumplattierung, umfassend:
ein Modul (10) zum Erfassen einer Ladestrategietabelle, das dazu konfiguriert ist, nach dem Empfang einer Batterieladeanweisung eine Batterieladestrategietabelle zu erfassen;
ein Lithiumplattierungsdetektier-Lademodul (20), das dazu konfiguriert ist, eine Batterie gemäß einem Ladestrom in der Batterieladestrategietabelle zu laden und während des Ladens der Batterie mindestens eine Lithiumplattierungserkennung an der Batterie durchführt, um ein erstes Lithiumplattierungserkennungsergebnis zu erhalten;
ein erstes Lademodul (30), das dazu konfiguriert ist, dass es: das Laden der Batterie gemäß dem Ladestrom und der Lithiumplattierungsdetektion der Batterie während des Ladens der Batterie fortsetzt, wenn das erste Lithiumplattierungsdetektionsergebnis lautet, dass kein Lithiumplattierungsphänomen auftritt, und die Lithiumplattierungsdetektion der Batterie stoppt, wenn das erste Lithiumplattierungsdetektionsergebnis lautet, dass das Lithiumplattierungsphänomen auftritt oder das Laden der Batterie abgeschlossen ist; und **gekennzeichnet durch**
ein zweites Lademodul (40), das dazu konfiguriert ist, den Ladestrom in der Batterieladestrategietabelle gemäß einer voreingestellten ersten Stromreduzierungsstrategie zu aktualisieren, wenn das erste Lithiumplattierungserkennungsergebnis lautet, dass das Lithiumplattierungsphänomen auftritt, und das Laden der Batterie gemäß dem aktualisierten Ladestrom fortsetzt, bis das Laden der Batterie abgeschlossen ist, wobei die Batterie unter Verwendung des aktualisierten Ladestroms in der Batterieladestrategietabelle geladen wird, wenn sie das nächste Mal die Ladeanweisung erhält.

8. Batterieladesystem auf der Grundlage der Lithiumplattierungserkennung gemäß Anspruch 7, das ferner umfasst:
ein Lithiumplattierungsdetektiermodul (50), das dazu konfiguriert ist, eine Lithiumplattierung an der Batterie zu detektieren, nachdem das Laden der Batterie abgeschlossen ist und sich die Batterie in einem statischen Zustand befindet, um ein zweites Lithiumplattierungserkennungsergebnis zu erhalten; und
ein Ladestrom-Aktualisierungsmodul (60), das dazu konfiguriert ist, den Ladestrom in der Batterieladestrategietabelle gemäß einer voreingestellten zweiten Stromreduzierungsstrategie zu aktualisieren, wenn das zweite Lithiumplattierungserkennungsergebnis ergibt, dass das Lithiumplattierungsphänomen auftritt.

9. Fahrzeug, das das Batterieladesystem auf der Grundlage der Lithiumplattierungserkennung gemäß Anspruch 7 oder 8 umfasst.

10. Computerlesbares Speichermedium, das ein Computerprogramm speichert, wobei bei Ausführung des Computerprogramms durch einen Prozessor das Batterieladungsverfahren auf der Grundlage einer Lithiumplattierungserkennung gemäß Anspruch 1 bis 6 implementiert wird.

## Revendications

1. Procédé de charge de batterie basé sur la détection du placage de lithium, comprenant :
acquérir (S10) un tableau de stratégie de charge de batterie après avoir reçu une instruction de charge de batterie ;
charger (S20) une batterie selon un courant de charge indiqué dans le tableau de stratégie de charge de batterie, et effectuer au moins une détection de placage de lithium sur la batterie pendant la charge de la batterie, afin d'obtenir un premier résultat de détection de placage de lithium ;
la poursuite (S30) de la charge de la batterie selon le courant de charge et la détection du placage de lithium de la batterie pendant la charge de la batterie lorsque le premier résultat de détection du placage de lithium indique qu'aucun phénomène de placage de lithium ne se produit, et l'arrêt de la détection du placage de lithium de la batterie lorsque le premier résultat de détection du placage de lithium indique que le phénomène de placage de lithium se produit ou que la charge de la batterie est terminée ; et **caractérisé par**
la mise à jour (S40) du courant de charge dans le tableau de stratégie de charge de batterie selon une première stratégie de réduction de courant prédéfinie lorsque le premier résultat de détection de placage de lithium indique que le phénomène de placage de lithium se produit, et la poursuite de la charge de la batterie selon le courant de charge mis à jour jusqu'à ce que la charge de la batterie soit terminée, dans lequel la batterie est chargée en utilisant le courant de charge mis à jour dans le tableau de stratégie de charge de batterie lors de la réception de la prochaine instruction de charge.

2. Procédé de charge de batterie basé sur la détection du placage de lithium selon la revendication 1, dans lequel, une fois la charge de la batterie terminée, le procédé comprend :
effectuer (S50) une détection de placage de lithium sur la batterie une fois que la charge de la batterie est terminée et que la batterie est dans un état statique, afin d'obtenir un deuxième résultat de détection de placage de lithium ; et
la mise à jour (S60) du courant de charge dans le tableau de stratégie de charge de batterie selon une deuxième stratégie de réduction de courant prédéfinie lorsque le deuxième résultat de détection de placage de lithium indique que le phénomène de placage de lithium se produit.

3. Procédé de charge de batterie basé sur la détection du placage de lithium selon la revendication 2, dans lequel l'exécution (S50) de la détection du placage de lithium sur la batterie après que la charge de la batterie est terminée et que la batterie est dans un état statique, afin d'obtenir un deuxième résultat de détection du placage de lithium, comprend :
collecter régulièrement une tension de la batterie à un intervalle de temps prédéfini après que la charge de la batterie est terminée et que la batterie est dans un état statique, et stocker de manière associative la tension collectée et un temps de collecte de la tension en tant que données de tension ;
la construction d'une courbe de tension différentielle dans le temps (L1) dans un système de coordonnées tension-temps selon les données de tension ; et
obtenir le deuxième résultat de détection de placage de lithium selon la courbe de tension différentielle dans le temps (L1) et un algorithme d'identification de pic prédéfini.

4. Procédé de charge de batterie basé sur la détection du placage de lithium selon la revendication 3, dans lequel la mise à jour (S60) du courant de charge dans le tableau de stratégie de charge de batterie selon une deuxième stratégie de réduction de courant prédéfinie comprend :
l'identification d'une tension de crête caractéristique (U2) dans la courbe de tension différentielle en fonction du temps (L1) à l'aide de l'algorithme d'identification de crête prédéfini, et l'enregistrement d'une tension stable correspondante (U3) lorsque la courbe de tension différentielle en fonction du temps (L1) atteint une norme de stabilité prédéfinie après avoir déterminé la tension de crête caractéristique ;
déterminer une première zone et une deuxième zone dans le système de coordonnées tension-temps selon la tension de crête caractéristique (U2), la tension stable (U3) et la courbe de tension différentielle dans le temps ;
déterminer une quantité représentative de placage de lithium de la batterie selon la première zone et la deuxième zone ; et
mettre à jour le courant de charge dans le tableau de stratégie de charge de la batterie selon la quantité représentative de placage de lithium et d'une norme de placage de lithium de batterie prédéfinie.

5. Procédé de charge de batterie basé sur la détection du placage de lithium selon l'une quelconque des revendications 1 à 4, dans lequel l'exécution (50) d'au moins une détection du placage de lithium sur la batterie pendant la charge de la batterie, afin d'obtenir un premier résultat de détection du placage de lithium, comprend :
l'acquisition (S201) d'une première impédance électrochimique et d'une deuxième impédance électrochimique de la batterie à une fréquence prédéfinie selon une variation SOC prédéfinie, dans lequel la variation SOC prédéfinie est égale à une différence entre une deuxième valeur SOC et une première valeur SOC ; la première valeur SOC correspond à la première impédance électrochimique ; la deuxième valeur SOC correspond à la deuxième impédance électrochimique ; et la première valeur SOC et la deuxième valeur SOC sont toutes deux supérieures à un seuil SOC prédéfini ; et
acquérir (S202) le premier résultat de détection de placage de lithium selon la première impédance électrochimique et la deuxième impédance électrochimique.

6. Procédé de charge de batterie basé sur la détection du placage de lithium selon la revendication 5, dans lequel l'acquisition (S201) du premier résultat de détection du placage de lithium de la batterie selon la première impédance électrochimique et la deuxième impédance électrochimique comprend :
déterminer que le premier résultat de détection de placage de lithium est que le phénomène de placage de lithium se produit lorsque la première impédance électrochimique est supérieure à la deuxième impédance électrochimique ; et
déterminer que le premier résultat détecteur de placage de lithium est qu'aucun phénomène de placage de lithium ne se produit lorsque la première impédance électrochimique est inférieure ou égale à la deuxième impédance électrochimique.

7. Système de charge de batterie basé sur la détection du placage de lithium, comprenant :
un module d'acquisition de tableau de stratégie de charge (10), configuré pour acquérir un tableau de stratégie de charge de batterie après avoir reçu une instruction de charge de batterie ;
un module de détection de placage de lithium de charge (20), configuré pour charger une batterie selon un courant de charge dans la table de stratégie de charge de batterie, et effectuer au moins une détection de placage de lithium de charge sur la batterie pendant la charge de la batterie, afin d'obtenir un premier résultat de détection de placage de lithium ;
un premier module de charge (30), configuré pour : poursuivre la charge de la batterie selon le courant de charge et détecter le placage de lithium de la batterie pendant la charge de la batterie lorsque le premier résultat de détection de placage de lithium indique qu'aucun phénomène de placage de lithium ne se produit, et arrêter la détection de placage de lithium de la batterie lorsque le premier résultat de détection de placage de lithium indique que le phénomène de placage de lithium se produit ou que la charge de la batterie est terminée ; et **caractérisé par**
un deuxième module de charge (40), configuré pour mettre à jour le courant de charge dans le tableau de stratégie de charge de batterie selon une première stratégie de réduction de courant prédéfinie lorsque le premier résultat de détection de placage de lithium indique que le phénomène de placage de lithium se produit, et poursuivre la charge de la batterie selon le courant de charge mis à jour jusqu'à ce que la charge de la batterie soit terminée, dans lequel la batterie est chargée à l'aide du courant de charge mis à jour dans le tableau de stratégie de charge de batterie lors de la réception de la prochaine instruction de charge.

8. Le système de charge de batterie basé sur la détection du placage de lithium selon la revendication 7, comprenant en outre :
un module de détection de placage de lithium (50), configuré pour effectuer une détection de placage de lithium sur la batterie une fois que la charge de la batterie est terminée et que la batterie est dans un état statique, afin d'obtenir un deuxième résultat de détection de placage de lithium ; et
un module de mise à jour du courant de charge (60), configuré pour mettre à jour le courant de charge dans le tableau de stratégie de charge de batterie selon une deuxième stratégie de réduction de courant prédéfinie lorsque le deuxième résultat de détection de placage de lithium indique que le phénomène de placage de lithium se produit.

9. Véhicule comprenant le système de charge de batterie basé sur la détection du placage de lithium selon la revendication 7 ou 8.

10. Support de stockage lisible par ordinateur, stockant un programme informatique, dans lequel, lorsque le programme informatique est exécuté par un processeur, le procédé de charge de batterie basé sur la détection du placage de lithium selon l'une quelconque des revendications 1 à 6 est implémenté.
